# EUROPÄISCHE PATENTSCHRIFT

(11) **EP 2 892 308 B1**
(45) Veröffentlichungstag und Bekanntmachung des Hinweises auf die Patenterteilung: **30.01.2019**
(21) Anmeldenummer: 14192233.6
(22) Anmeldetag: 07.11.2014
(51) Int. Cl.: H05K 3/00, H05K 3/42, H05K 3/46

(54) **Verfahren zur Via-Stift-Verfüllung**
Method for via-pin filling
Procédé destiné au remplissage par crayon

(30) Priorität: 03.12.2013 DE 102013224765
(43) Veröffentlichungstag der Anmeldung: 08.07.2015
(73) Patentinhaber: ROBERT BOSCH GMBH, 70442 Stuttgart (DE)
(72) Erfinder: Steinberg, Rene, 31135 Hildesheim (DE)

(56) Entgegenhaltungen:
- DE-A1- 10 206 440
- DE-A1- 10 304 867
- US-A1- 2009 094 825

## Beschreibung

Die Erfindung betrifft ein Verfahren zum Verfüllen einer Durchkontaktierung (Via) für mehrlagige Leiterplatten. Die Erfindung betrifft somit den Plugging-Prozess.

### Stand der Technik

Bei der Herstellung von mehrlagigen Leiterplatten werden üblicherweise mehrere dünne kupferbeschichtete, epoxyharzgetränkte Glasfasermatten (wie FR4-Material) mittels Druck und Wärme miteinander verpresst. Die elektrischen Verbindungen zwischen den Lagen werden mit Durchkontaktierungen hergestellt. Im Folgenden werden die einzelnen Schichten einer mehrlagigen Leiterplatte als Lagen bezeichnet. Unter einer Durchkontaktierung ist eine vertikale elektrische Verbindung zwischen den Leiterbahnebenen einer Leiterplatte, beziehungsweise einer Lage, zu verstehen. Die Verbindung wird meist durch eine galvanisch metallisierte Bohrung zwischen den Lagen realisiert. Reicht die Durchkontaktierung nicht durch die ganze mehrlagige Leiterplatte, sondern nur bis zu einer der Lagen, nennt man die Durchkontaktierung Blind-Via. Befinden sich die Durchkontaktierungen "Vergraben" zwischen den Lagen, werden sie Buried-Via bezeichnet.

Wenn die Durchkontaktierungen nicht verschlossen sind, kann bei durchgehenden Bohrungen, beziehungsweise Durchkontaktierungen, das Lotdepot abfließen und somit die Zuverlässigkeit der Lötstelle und damit der gesamten Schaltung nachteilig beeinflussen. Ferner würde bei einer nicht gefüllten Durchkontaktierung zwischen den Lagen (Buried-Via) die Gefahr bestehen, dass das Material (beispielsweise Harz) der epoxyharzgetränkten Glasfasermatten beim Verpressen der Lagen in diese Löcher, beziehungsweise Buried-Vias, fließt. Hierbei können Fehlstellen sowie Lufteinschlüsse entstehen, die sich nachteilig auf die Qualität der Leiterplatte auswirken.

Im Stand der Technik ist deshalb bekannt, die Durchkontaktierungen mittels spezieller (Plugging-) Pasten zu verfüllen, beziehungsweise zu schließen. Dies wird üblicherweise mit den folgenden Schritten durchgeführt:
1. Die Durchkontaktierung mit einer Paste im Druckverfahren mit oder ohne Sieb verfüllen,
2. Material trocknen lassen,
3. überschüssiges Material abschleifen,
4. die Oberflächen reinigen,
5. eventuell abgetragenes Kupfer aufgalvanisieren.

Nach dem Verfüllen der Durchkontaktierungen einer Platte, kann diese weiterverarbeitet werden. Beispielsweise kann diese Lage im Anschluss mit anderen Lagen verpresst werden.

In der DE 10 2005 020 969 A1 wird eine Füllplattierungsstruktur eines inneren Via-Lochs beschrieben. Dabei wird eine erste plattierte Schicht auf einer Innenwandung des Via-Lochs, unter Verwendung eines Impulsumkehrplattierungsprozesses glockenförmig ausgebildet, woraufhin ein Umkehrstrom transformiert wird, um eine zweite Plattierungsschicht auf oberen und unteren Abschnitten der ersten Plattierungsschicht der Innenwandung des Via-Lochs derart zu bilden, dass das Via-Loch gefüllt wird.

In der DE 10 2007 008 491 A1 wird eine Leiterplatte mit innenliegender Durchgangsbohrung sowie ein Herstellungsverfahren dafür beschrieben. Dabei weist die Leiterplatte eine Kernschicht, in welcher eine innenliegende Durchgangsbohrung ausgebildet ist, eine erste Galvanisierungsschicht, die einen Eingang der inneren Durchgangsbohrung verschließt, wobei in der innenliegenden Durchgangsbohrung ein verbleibender Raum nicht gefüllt zurückbleibt, und eine zweite Galvanisierungsschicht, die den anderen Eingang der innenliegenden Durchgangsbohrung verschließt und den verbleibenden Raum füllt, auf.

Aus der DE 103 04 867 A1 sind ein Verfahren und eine Vorrichtung zur Herstellung einer Leiterplattenanordnung mit wenigstens einer Trägerplatte aus elektrisch isolierendem Material bekannt, bei welchem Verfahren wenigstens eine elektrisch leitende Querverbindung durch wenigstens eine Trägerplatte hindurch dadurch erstellt wird, dass ein die Querverbindung bildender elektrisch leitender Stift, dessen Länge wenigstens der Dicke der Trägerplatte entspricht, quer zur Trägerplatte derart in die Trägerplatte eingeschlossen wird, dass der Stift die Trägerplatte durchdringt und seine Längsenden an den Plattenflächen der Träger platte freigelegt sind. Ein Auffüllen einer Durchgangsbohrung einer leitenden Durchkontaktierung ist darin nicht beschrieben.

Aus der DE 102 06 440 A1 sind ein Verfahren und eine Vorrichtung zum Herstellen elektrisch leitender Verbindungen bekannt. Beschrieben wird ein Verfahren zum Herstellen von Durchkontaktierungslöchern in einem Substrat. Hierfür ist eine Dispenservorrichtung mit einer Stanz- oder Lochervorrichtung kombiniert, welche in dem Substrat Kontaktierungslöcher oder Ausnehmungen einbringt. Im weiteren Verfahren werden diese Löcher oder Ausnehmungen mittels der Dispenservorrichtung mit Leitkleber verfüllt und gegebenenfalls untereinander verbunden. Es wird somit in einem Schritt mittels der Dispenservorrichtung sofort eine die Kontaktierungslöcher vollständig ausfüllende Kontaktierung gebildet.

Aus der US 2009/0094825 A1 ist ein Verfahren zum Herstellen eines Substrats bekannt, das folgende Schritte umfasst: Formen eines Durchgangslochs in einem Grundelement; Überziehen des Grundelements mit einer Metallschicht, um eine innere Oberfläche des Durchgangslochs mit einer metallisierten Schicht zu überziehen; Aufbringen eines Photolacks auf das Grundelement; optisches Belichten und Entwickeln des Photolacks, um ein Photolackmuster zu bilden, das wenigstens einen ebenen Bereich des Durchgangslochs bedeckt; sowie Ätzen einer elektrisch leitenden Schicht, die auf der Oberfläche des Grundelements gebildet ist, wobei das Photolackmuster als Ätzmaske dient. Das Photolackmuster ist gebildet, um einen Bereich, in dem die leitende Schicht freigelegt ist, um einen vorgegebenen Abstand von einer Kante des Durchgangslochs zu trennen, und der vorgegebene Abstand ist größer als ein Abstand des Ätzens einer Seitenfläche der leitenden Schicht im genannten Ätzschritt. Das Innere der Durchgangslöcher kann durch Gewebefilmdruck mit Kunstharz gefüllt werden, das durch eine Wärmebehandlung ausgehärtet wird.

### Offenbarung der Erfindung

Aufgabe der vorliegenden Erfindung ist es, ein Verfahren zum Verfüllen einer Durchkontaktierung für eine mehrlagige Leiterplatte im Vergleich zu den aus dem Stand der Technik bekannten Verfahren kostengünstiger, qualitativ besser (Oberfläche) und zeitlich kürzer auszugestalten.

Erfindungsgemäß wird ein Verfahren zum Verfüllen einer Durchkontaktierung nach Anspruch 1 vorgeschlagen, wobei die Durchkontaktierung innerhalb einer mehrlagige Leiterplatte angeordnet ist, und wobei eine Seitenwand der Durchkontaktierung vollumfänglich mit einer Metallschicht versehen ist. Das erfindungsgemäße Verfahren weist dabei die folgenden Schritte auf:
a) Ausrichten eines Stiftes senkrecht zu einer ersten Öffnung der Durchkontaktierung;
b) Einführen des Stiftes durch die erste Öffnung in die Durchkontaktierung;
c) Kürzen des Stiftes auf eine Stiftlänge, derart, dass die Stiftlänge ein Teil oder ein Ganzes oder ein Vielfaches einer Länge der Durchkontaktierung entspricht;
d) Verpressen der ersten Lage mit einer zweiten Lage, wobei zwischen der ersten Lage und der zweiten Lage eine erste Prepegschicht, beispielsweise eine erste Laminatschicht, angeordnet wird, wobei in Schritt d) solange die erste Lage mit der zweiten Lage verpresst wird, bis sich der Stift innerhalb der Durchkontaktierung derart verformt, dass durch den Stift im Wesentlichen die gesamte Durchkontaktierung ausgefüllt ist.

Unter einem Stift ist erfindungsgemäß ein länglich ausgebildeter Gegenstand, welcher bei Raumtemperatur und ohne Einfluss von Kräften im Wesentlichen ein festes Material aufweist. Dabei kann das Material weich oder auch elastisch ausgebildet sein. Das Material des Stiftes ist somit bevorzugterweise verformbar, aber fester ausgebildet als beispielsweise eine üblicherweise verwendete Paste zum Verfüllen einer Durchkontaktierung. Die erste Öffnung der Durchkontaktierung befindet sich bevorzugterweise im Bereich der Oberseite der ersten Lage für eine mehrlagige Leiterplatte.

Nach dem Ausrichten des Stiftes sowie dem Einführen des Stiftes durch die erste Öffnung in die Durchkontaktierung hinein, wird in Schritt c) der Stift in seiner Länge auf eine vorbestimmte Stiftlänge gekürzt. Nach Kürzen des Stiftes weist der Stift eine Stiftlänge auf, welche einstellbar von einem Teil bis zu einem Vielfachen der Länge der Durchkontaktierung ist. Bevorzugterweise ist die Stiftlänge stufenlos einstellbar.

Die erste Prepegschicht, sowie bevorzugterweise weitere Prepegschichten, kann als harzgetränkte Matte, beispielsweise als epoxyharzgetränkte Glasfasermatte, ausgebildet sein.

Nach Ausrichten, Einführen und Kürzen des Stiftes, wird die erste Lage mit der zweiten Lage verklebt und miteinander verpresst. Dadurch, dass die Durchkontaktierung vor dem Verpressen der ersten Lage mit der zweiten Lage mindestens teilweise mit dem Stift ausgefüllt wurde, kann beim Verpressen der Lagen kein oder nur sehr wenig Harz des Prepregs, beziehungsweise der ersten Prepegschicht, in die Durchkontaktierung hineinfließen. Ein Lufteinschluß kann somit zum größten Teil oder ganz vermieden werden.

Der Stift weist einen runden oder eckigen Querschnitt auf. Bevorzugterweise weist die Oberfläche des Stiftes eine Rauigkeit auf. Besonders bevorzugterweise weist die Oberfläche des Stiftes mit rundem Querschnitt eine Rauigkeit auf oder der Stift weist einen eckigen Querschnitt auf. Dadurch haftet der Stift nach Einführen des Stiftes durch die erste Öffnung in die Durchkontaktierung innerhalb der Durchkontaktierung.

Im Vergleich zu aus dem Stand der Technik bekannten Verfahren zum Verfüllen einer Durchkontaktierung ist das erfindungsgemäße Verfahren wesentlich einfacher ausgestaltet. Somit lässt sich das erfindungsgemäße Verfahren wesentlich schneller durchführen. Beispielsweise sind bei dem erfindungsgemäßen Verfahren kein Abschleifen des überschüssigen Materials und auch kein Reinigen notwendig. Des Weiteren wird überschüssiges Abfallmaterial, beispielsweise, welches beim Abschleifen entsteht, komplett vermieden. Der Stift wird nach Einführen durch die erste Öffnung in die Durchkontaktierung auf eine vorbestimmte Stiftlänge gekürzt. Ein weiteres Nachbearbeiten ist hierbei nicht erforderlich. Die Qualität der Kupferoberfläche wird bei diesem Prozess durch das fehlende Schleifen ebenfalls nicht beeinträchtigt.

Bevorzugterweise wird der Stift in Schritt b) über mindestens die gesamte Länge der Durchkontaktierung durch die erste Öffnung in die Durchkontaktierung eingeführt. Dabei ist bevorzugterweise vorgesehen, dass der Stift mit seinem ersten Ende im Bereich einer zweiten Öffnung der Durchkontaktierung mit einer Seitenfläche der ersten Lage abschließt oder aus der zweiten Öffnung hervorsteht. Bei der zweiten Öffnung der Durchkontaktierung handelt es sich um die der ersten Öffnung gegenüberliegende Öffnung der ersten Lage.

Des Weiteren ist bevorzugterweise vorgesehen, dass der Stift in Schritt b) mittels eines Mittels zum Einführen in die Durchkontaktierung eingeführt wird. Hierfür kann eine Maschine oder ein Automat vorgesehen sein, welche, beziehungsweise welcher, das Mittel zum Einführen aufweist. Ferner kann das Mittel zum Einführen des Stiftes als ein dem Zweck entsprechend umgebauter Bestückerkopf eines Bestückautomaten oder Bohrkopf eines Bohrautomaten ausgebildet sein. Bei der Maschine oder dem Automaten kann es sich um jede geeignete Vorrichtung handeln, auf oder in welcher eine Leiterplatte, beziehungsweise eine oder mehrere Lagen einer mehrlagigen Leiterplatte eingespannt oder aufgelegt werden können. Die Maschine oder der Automat weist das Mittel zum Einführen des Stiftes auf, welchem der Stift zur Einführung in die Durchkontaktierung zugeführt wird. Das Mittel zum Einführen des Stiftes kann zumindest in zwei Richtungen bewegt werden, um während Schritt a) den Stift senkrecht zur ersten Öffnung der Durchkontaktierung auszurichten. Bevorzugterweise kann das Mittel zum Einführen des Stiftes auch in seiner Höhe beziehungsweise im Abstand zur Leiterplatte, beziehungsweise im Abstand zur ersten Lage, variiert werden, um den Stift in Schritt b) durch die erste Öffnung in die Durchkontaktierung einzuführen. Das Material des Stiftes wird dem Mittel zum Einführen des Stiftes als stangenförmiges Ausgangsmaterial oder in aufgewickelter Form, beispielsweise von einer Rolle, zugeführt. Dabei kann die Rolle mit dem aufgewickelten Stiftmaterial am oder in der Maschine oder dem Automaten anordbar sein.

Ferner ist bevorzugterweise vorgesehen, dass der Stift ein Glasfasergewebe zur Stabilisierung aufweist. Des Weiteren weist der Stift bevorzugterweise ein Epoxidmaterial auf.

Ferner ist bevorzugterweise vorgesehen, dass der Stift einen im Wesentlichen kreisrunden Durchmesser aufweist oder einen eckigen Querschnitt besitz. Dabei ist der Stiftdurchmesser bevorzugterweise kleiner als der Durchmesser der Durchkontaktierung. Bei einem Stift mit eckigem Querschnitt ist bevorzugterweise die maximale Breite des Stiftes im Inneren der Durchkontaktierung kleiner als Durchmesser der Durchkontaktierung. Besonders bevorzugterweise beträgt der Stiftdurchmesser, beziehungsweise die maximale Breite des Stiftes, mindestens 75 %, ganz besonders bevorzugterweise mindestens 85 %, des Durchmessers der Durchkontaktierung. Beispielsweise könnte der Durchmesser der Durchkontaktierung im Bereich zwischen 150 Mikrometer und 250 Mikrometer liegen. Bevorzugterweise weist der Stift einen Stiftdurchmesser, beziehungsweise eine maximale Breite, im Bereich zwischen 125 Mikrometern und 225 Mikrometern auf.

Bei eckiger Ausführung ist die Haftung des Stiftes in der Hülse begünstigt.

Erfindungsgemäß wird während Schritt d) die erste Lage mit der zweiten Lage solange verpresst, bis der Stift innerhalb der Durchkontaktierung die Durchkontaktierung ganz oder teilweise, besonders bevorzugterweise zu 75 %, ganz besonders bevorzugterweise zumindest zu 85 %, verschlossen hat. Bevorzugterweise wird durch das Verpressen der ersten Lage mit der zweiten Lage der Stift, beziehungsweise das Material des Stiftes, innerhalb der Durchkontaktierung weich bis liquide und verschließt das Loch, beziehungsweise die Durchkontaktierung, sodass kein oder sehr viel weniger Harz der laminierten Lagen in die Durchkontaktierung abfließen kann.

Bevorzugterweise wird der Stift soweit in die Durchkontaktierung eingeführt und der Stift derart in seiner Länge gekürzt, dass nach dem Kürzen des Stiftes in Schritt c) der Stift mit einem ersten Ende aus der zweiten Öffnung herausragt. Das heißt, dass der Stift aus der der ersten Öffnung gegenüberliegenden Öffnung der Durchkontaktierung über eine erste Länge heraussteht. Alternativerweise oder zusätzlich ist bevorzugterweise vorgesehen, dass der Stift nach dem Kürzen in Schritt c) mit einem zweiten Ende aus der ersten Öffnung der Durchkontaktierung über eine zweite Länge heraussteht. Somit ist bevorzugterweise vorgesehen, dass der Stift nach Einführen in die Durchkontaktierung und Kürzen des Stiftes, zumindest aus einer der beiden Öffnungen der Durchkontaktierung heraussteht, beziehungsweise über eine erste Länge und/oder eine zweite Länge heraussteht. Somit weist der Stift nach Einführen in die Durchkontaktierung und Kürzen eine Stiftlänge auf, welche bevorzugterweise länger ist als die Länge, beziehungsweise Tiefe, der Durchkontaktierung.

Außerdem ist bevorzugterweise vorgesehen, dass die erste Länge, über welche der Stift aus der zweiten Öffnung der Durchkontaktierung heraussteht, im Wesentlichen in einer geraden Linie mit dem Bereich des Stiftes, welcher innerhalb der Durchkontaktierung angeordnet ist, verläuft.

Des Weiteren ist bevorzugterweise vorgesehen, dass die zweite Länge, über welche der Stift aus der ersten Öffnung der Durchkontaktierung heraussteht, in einer im Wesentlichen geraden Linie mit dem Bereich des Stiftes, welcher innerhalb der Durchkontaktierung angeordnet ist, verläuft.

Im Bereich seines ersten Endes ist der Stift bevorzugterweise abgeknickt. Des Weiteren ist bevorzugterweise vorgesehen, dass der Stift im Bereich seines zweiten Endes abgeknickt ist. Somit kann der Stift bevorzugterweise im Bereich der Oberseite und/oder Unterseite der ersten Lage verkantet angeordnet sein. Das heißt, dass der Stift im Bereich seiner ersten Länge, über welche der Stift aus der zweiten Öffnung der Durchkontaktierung heraussteht, in einem Winkel zum Bereich des Stiftes, welcher innerhalb der Durchkontaktierung angeordnet ist, angeordnet ist. Ferner kann der Stift im Bereich seiner zweiten Länge, über welche der Stift aus der ersten Öffnung der Durchkontaktierung heraussteht, in einem Winkel zum Bereich des Stiftes, welcher innerhalb der Durchkontaktierung angeordnet ist, angeordnet sein. Besonders bevorzugterweise ist der Winkel zwischen dem Bereich der ersten Länge und dem Bereich des Stiftes innerhalb der Durchkontaktierung zwischen 80° und 100°, ganz besonders bevorzugterweise im Wesentlichen rechtwinklig. Des Weiteren ist der Winkel zwischen dem Bereich der zweiten Länge und dem Bereich des Stiftes innerhalb der Durchkontaktierung zwischen 80° und 100°, ganz besonders bevorzugterweise rechtwinklig.

Das vorbeschriebene Verfahren ist bevorzugterweise für Buried-Vias vorgesehen. Für Blind- und Thru-Hole Vias (Durchkontaktierung) ist zusätzlich vorzugsweise vorgesehen, dass ein oder mehrere Prozessschritte dem beschriebenen Verfahren hinzugefügt werden. Das betrifft insbesondere dem zusätzlichen Verpressen (Wärmezuführung) der fertig laminierten Leiterplatte, um den Via-Stift zu schmelzen und damit das Loch zu verschliessen.

Die Erfindung wird nun mit Bezug auf die begleitenden Zeichnungen, anhand besonders bevorzugter Ausführungsformen beispielhaft erläutert.

Es zeigen schematisch:
Figur 1 eine schnittbildliche Ansicht einer Leiterplatte, während des Ausrichtens eines Stiftes senkrecht zu einer ersten Öffnung der Durchkontaktierung,
Figur 2 eine schnittbildliche Ansicht einer Leiterplatte, während des Einführens des Stiftes durch die erste Öffnung in die Durchkontaktierung,
Figur 3a eine schnittbildliche Ansicht einer Leiterplatte, während des Verpressens der ersten Lage mit einer zweiten Lage,
Figur 3b eine schnittbildliche Ansicht einer Leiterplatte, während des Verpressens der ersten Lage mit einer zweiten und einer dritten Lage,
Figur 4 eine schnittbildliche Ansicht eines Mittel zum Einführen des Stiftes, und
Figur 5 eine perspektivische Ansicht einer Maschine mit einem Mittel zum Einführen des Stiftes .

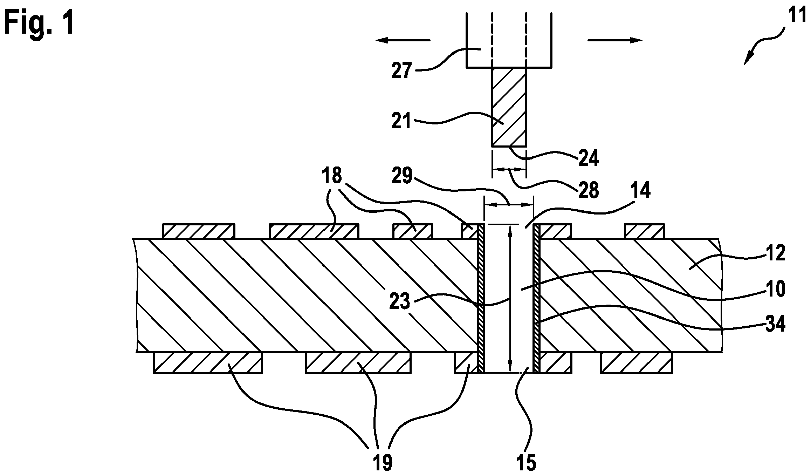

Die Figuren 1 bis 3 zeigen eine schnittbildliche Darstellung einer Leiterplatte 11. In den Figuren 1 bis 3 ist dabei ein Ausschnitt einer Leiterplatte 11 gezeigt. Auf der Oberseite der ersten Lage 12 ist eine erste Kupferschicht 18 angeordnet. Auf der Unterseite der ersten Lage 12 ist eine zweite Kupferschicht 19 angeordnet. Zur elektrischen Verbindung der ersten Kupferschicht 18 auf der Oberseite der ersten Lage 12 mit der zweiten Kupferschicht 19 auf der Unterseite der ersten Lage 12 ist eine Durchkontaktierung 10 in der ersten Lage 12 angeordnet. Die Seitenwand der Durchkontaktierung 10 ist vollumfänglich mit einer Metallschicht 34 versehen, um die erste Kupferschicht 18 mit der Kupferschicht 19 elektrisch zu verbinden.

Der in den Figuren 1 bis 3 gezeigte Ausschnitt einer Leiterplatte 11 zeigt lediglich ein Beispiel für eine Leiterplatte 11. Der Schichtaufbau einer mehrlagigen Leiterplatte könnte aus mehr Lagen bestehen oder in einer anderen geeigneten Weise aufgebaut sein.

Zum Verfüllen der Durchkontaktierung 10 ist vorgesehen, den Stift 21 in der Durchkontaktierung 10 anzuordnen, um die Durchkontaktierung 10 zumindest teilweise auszufüllen, damit beim Zusammenpressen der ersten Lage 12 mit der zweiten Lage 13 und/oder der dritten Lage 13a das Harz, beziehungsweise das Material, der ersten Prepegschicht 16 zwischen der ersten Lage 12 und der zweiten Lage 13 nicht oder nur in geringem Maße in den Bereich der Durchkontaktierung 10 fließen kann. Ferner kann somit auch das Material der zweiten Prepegschicht 17 zwischen der ersten Lage 12 und der dritten Lage 13a nicht oder nur in geringem Maße in den Bereich der Durchkontaktierung 10 fließen

In Figur 1 ist der Schritt des Ausrichtens des Stiftes 21 gezeigt. Dabei ist der Stift 21 auf eine Rolle aufgewickelt oder als Stangenmaterial in einem Magazin stehend und in einer Maschine 26 eingespannt. In der Maschine 26 wird der Stift 21 dem Mittel zum Einführen des Stiftes 27 zugeführt. Die Rolle oder das Magazin sowie die Maschine 26 sind in Figur 1 nicht gezeigt.

Das Mittel zum Einführen des Stiftes 27 wird oberhalb der in der Maschine 26 eingespannten ersten Lage 12 derart ausgerichtet, dass der Stift 21 mit seinem ersten Ende 24 senkrecht über einer ersten Öffnung 14 der Durchkontaktierung 10 angeordnet ist. Der Stift 21 weist dabei einen geringeren Durchmesser 28 auf als der Durchmesser 29 der Durchkontaktierung 10. Die Durchkontaktierung 10 weist eine Länge 23 auf. Da der Stift 21 in seiner Ausgangslage aufgewickelt oder als Stange ausgeführt ist, weist dieser, in dieser Ausgangslage, eine sehr große Länge auf, wobei der Stift 21 nach Einführen des Stiftes 21 in die Durchkontaktierung 10 und durch Kürzen, beziehungsweise Abschneiden, auf eine vorgegebene Stiftlänge gebracht wird.

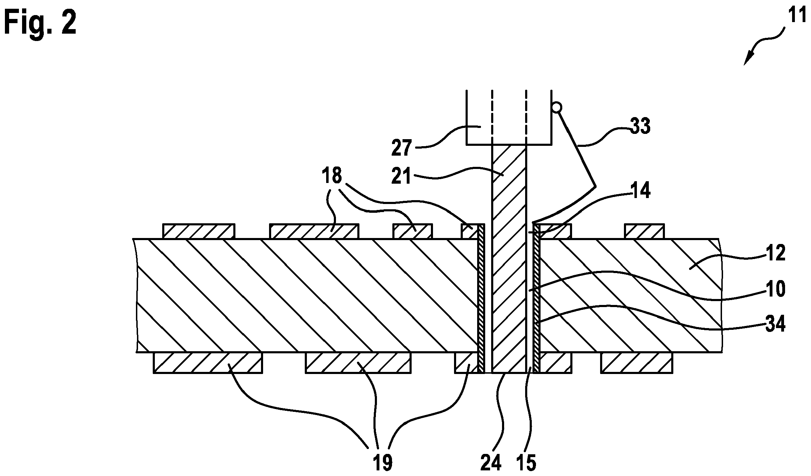

Figur 2 zeigt den Schritt des Einführens des Stiftes 21 durch die erste Öffnung 14 in die Durchkontaktierung 10. Wie in Figur 2 gezeigt ist, ist der Stift 21 mit seinem ersten Ende 24 bis in den Bereich der zweiten Öffnung 15 der Durchkontaktierung 10 eingeführt. Im nächsten Schritt wird der Stift 21 mittels eines Schneidemittels 33 im Bereich der ersten Öffnung 14 der Durchkontaktierung 10 abgeschnitten, beziehungsweise auf die gewünschte Stiftlänge gekürzt.

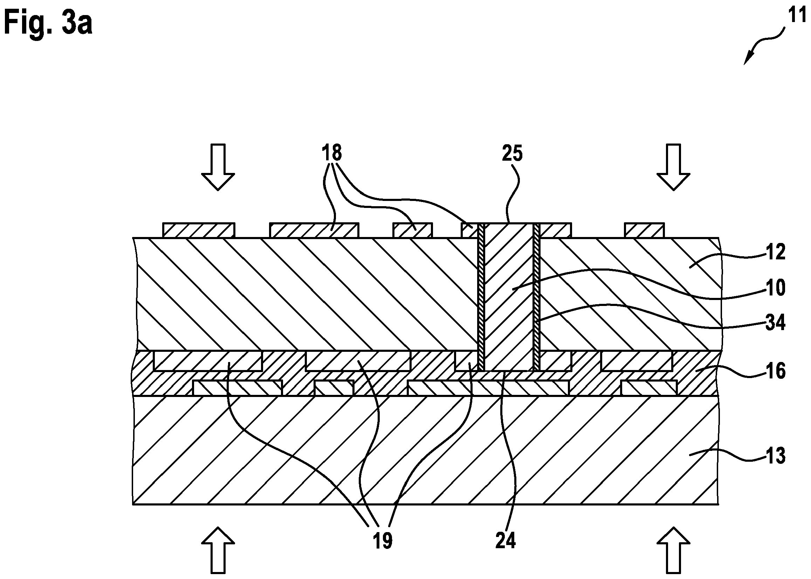

Figur 3a zeigt die Leiterplatte 11, beziehungsweise den Ausschnitt einer Leiterplatte 11, nach Einführen des Stiftes 21 in die Durchkontaktierung 10 und Kürzen des Stiftes 21 auf eine Stiftlänge, wobei die Stiftlänge der Länge 23 der Durchkontaktierung 10 entspricht.

Wie in Figur 3a ferner gezeigt ist, wird nach Einführen des Stiftes 21 und Kürzen des Stiftes 21 die erste Lage 12 mit der zweiten Lage 13 derart verpresst, dass sich der Stift 21 innerhalb der Durchkontaktierung 10 soweit verformt, dass durch den Stift 21 im Wesentlichen die gesamte Durchkontaktierung 10 ausgefüllt ist. Das Harz der ersten Prepegschicht 16 kann somit nicht oder nur in sehr geringem Maße in den Bereich der Durchkontaktierung 10 eintreten, beziehungsweise hineinfließen.

Das in Figur 3a gezeigte Verpressen der ersten Lage 12 mit der zweiten Lage 13 ist insbesondere bei Buried-Vias in der ersten Lage 12 vorgesehen.

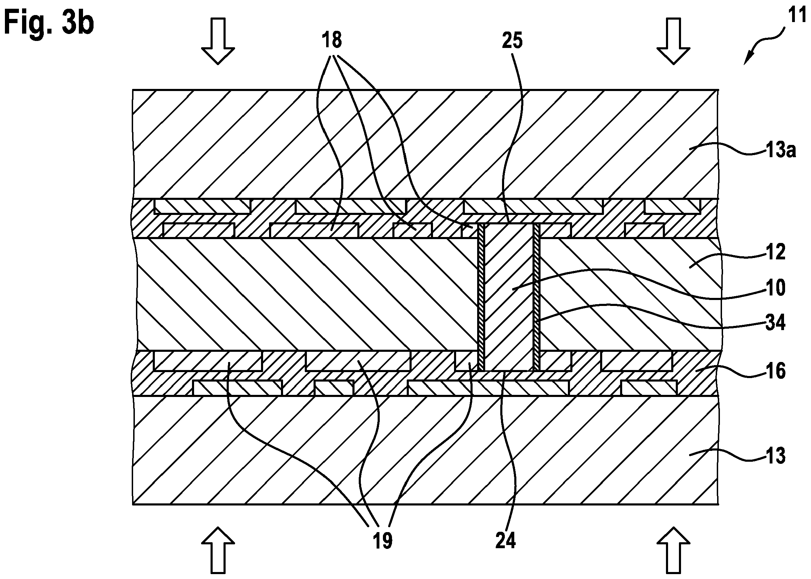

Ein Verpressen der ersten Lage 12 mit einer zweiten Lage 13 und einer dritten Lage 13a ist in Figur 3b gezeigt. Dies ist insbesondere für Blind- und Thru-Hole Vias vorgesehen.

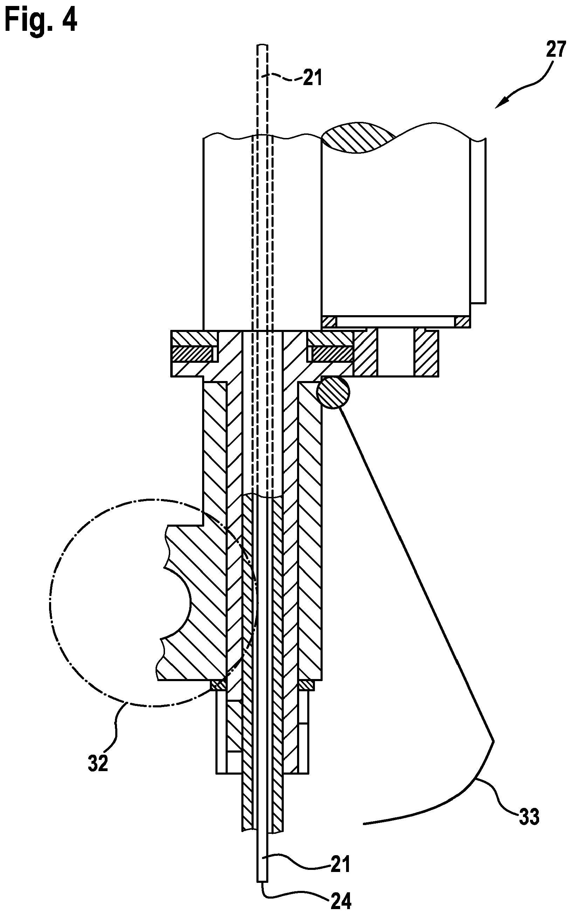

Figur 4 zeigt ein Mittel 27zum Einführen des Stiftes 21, mit darin eingespanntem Stift 21. Der im Mittel 27zum Einführen des Stiftes 21 eingespannte Stift 21 wird mittels eines Vortriebs 32 nach unten in eine Durchkontaktierung 10 geschoben. Ferner ist in Figur 4 ein Schneidemittel 33 gezeigt, welches ebenfalls am Mittel 27 zum Einführen des Stiftes 21 angeordnet ist. Bei dem Mittel 27 zum Einführen des Stiftes 21 kann es sich um einen dem Zweck entsprechend umbebauten Kopf in einem Bohrautomaten oder einem Bestückautomaten handeln.

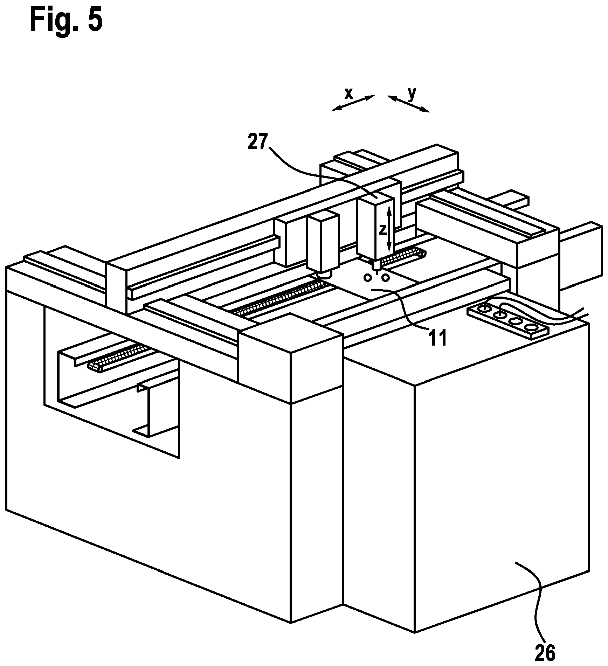

Figur 5 zeigt eine Maschine 26 mit einer in der Maschine 26 eingespannten oder aufgelegten mehrlagigen Leiterplatte 11. Dabei wird das Mittel 27 zum Einführen des Stiftes 21 oberhalb der ersten Lage 12 der mehrlagigen Leiterplatte 11 derart ausgerichtet, dass der im Mittel 27 zum Einführen des Stiftes 21 eingespannte Stift 21 mit seinem ersten Ende 24 senkrecht zu einer ersten Öffnung 14 der Durchkontaktierung 10 ausgerichtet ist. Hierfür kann ein dem Zweck entsprechend umgebauter Bohrautomat bzw. Bohrkopf oder Bestückautomat beziehungsweise Bestückerkopf vorgesehen sein.

Nach Durchführen der weiteren Schritte zum Verfüllen der Durchkontaktierung 10 mit dem Stift 21 werden diese Verfahrensschritte für die weiteren Durchkontaktierungen in der ersten Lage 12 der mehrlagigen Leiterplatte 11 wiederholt, bevor die Lagen 12, 13, 13a miteinander verpresst werden.

Dasselbe Verfahren kann nach Aufbringen einer weiteren Lage für die Durchkontaktierungen in der weiteren Lage durchgeführt werden.

## Patentansprüche

1. Verfahren zum Verfüllen einer Durchkontaktierung (10), wobei die Durchkontaktierung (10) in mindestens einer ersten Lage (12) für eine mehrlagige Leiterplatte (11) angeordnet ist, und wobei eine Seitenwand der Durchkontaktierung (10) vollumfänglich mit einer Metallschicht (34) versehen ist,
**gekennzeichnet durch folgende Schritte:**
a) Ausrichten eines Stiftes (21) senkrecht zu einer ersten Öffnung (14) der Durchkontaktierung (10);
b) Einführen des Stiftes (21) durch die erste Öffnung (14) in die Durchkontaktierung (10);
c) Kürzen des Stiftes (21) auf eine Stiftlänge, derart, dass die Stiftlänge einem Teil einem Ganzen oder einem Vielfachen einer Länge (23) der Durchkontaktierung (10) entspricht;
d) Verpressen der ersten Lage (12) mit einer zweiten Lage (13), wobei zwischen der ersten Lage (12) und der zweiten Lage (13) eine erste Prepregschicht (16) angeordnet wird, wobei in Schritt d) solange die erste Lage (12) mit der zweiten Lage (13) verpresst wird, bis sich der Stift (21) innerhalb der Durchkontaktierung (10) derart verformt, dass durch den Stift (21) im Wesentlichen die gesamte Durchkontaktierung (10) ausgefüllt ist.

2. Verfahren gemäß Anspruch 1,
**dadurch gekennzeichnet,**
**dass** in Schritt d) die erste Lage (12) mit einer dritten Lage (13a) verpresst wird, wobei zwischen der ersten Lage (12) und der drittten Lage (13a) eine zweite Prepegschicht (17) angeordnet wird, wobei die erste Lage (12) zwischen der zweiten Lage (13) und der dritten Lage (13a) angeordnet wird.

3. Verfahren gemäß Anspruch 1 oder 2,
**dadurch gekennzeichnet,**
**dass** in Schritt b) der Stift (21) über mindestens die gesamte Länge (23) der Durchkontaktierung (10) durch die erste Öffnung (14) in die Durchkontaktierung (10) eingeführt wird, wobei der Stift (21) mit seinem ersten Ende (24) im Bereich einer der ersten Öffnung (14) gegenüberliegenden zweiten Öffnung (15) der Durchkontaktierung (10) mit der ersten Lage (12) abschließt oder aus der zweiten Öffnung (15) hervorsteht.

4. Verfahren gemäß einem der vorhergehenden Ansprüche,
**dadurch gekennzeichnet,**
**dass** der Stift (21) in Schritte b) mittels eines Mittels (27) zum Einführen des Stiftes (21) in die Durchkontaktierung (10) eingeführt wird, wobei der Stift (21) stangenförmig oder aufgewickelt dem Mittel (27) zum Einführen des Stiftes (21) zugeführt wird.

5. Verfahren gemäß einem der vorhergehenden Ansprüche,
**dadurch gekennzeichnet,**
**dass** der Stift (21) ein Glasfasergewebe zur Stabilisierung aufweist.

6. Verfahren gemäß einem der vorhergehenden Ansprüche,
**dadurch gekennzeichnet,**
**dass** der Stift (21) ein Epoxidmaterial aufweist.

7. Verfahren gemäß einem der vorhergehenden Ansprüche,
**dadurch gekennzeichnet,**
**dass** der Stift (21) einen Stiftdurchmesser (28) aufweist, welcher kleiner als ein Durchmesser (29) der Durchkontaktierung (10) ist, und wobei der Stift (21) einen runden oder eckigen Querschnitt aufweist.

8. Verfahren gemäß einem der vorhergehenden Ansprüche,
**dadurch gekennzeichnet,**
**dass** nach dem Kürzen des Stifts (21) in Schritt c) der Stift (21) mit einem ersten Ende (24) und/oder zweiten Ende (25) aus der ersten Öffnung (14) der Durchkontaktierung (10) und/oder aus einer der ersten Öffnung (14) gegenüberliegenden zweiten Öffnung (15) der Durchkontaktierung (10) über eine erste Länge und/oder eine zweite Länge heraussteht.

9. Verfahren gemäß Anspruch 8,
**dadurch gekennzeichnet,**
**dass** die erste Länge und/oder die zweite Länge (31) mit dem Bereich des Stifts (21) innerhalb der Durchkontaktierung (10) in einer im Wesentlichen geraden Linie verläuft.

10. Verfahren gemäß Anspruch 8 oder 9,
**dadurch gekennzeichnet,**
**dass** der Stift (21) im Bereich seines ersten Endes (24) und/oder zweiten Endes (25) geknickt wird.

11. Verfahren gemäß einem der vorhergehenden Ansprüche,
**dadurch gekennzeichnet,**
**dass** nach dem Verpressen in Schritt d) die mehrlagige, fertig laminierte Leiterplatte (11) in einem weiteren Verfahrensschritt verpresst wird oder dieser zumindest im Bereich des Stiftes (21) Wärme zugeführt wird um das Material des Stiftes (21) zu schmelzen und damit die erste Öffnung (14) zu verschliessen.

## Claims

1. Method for filling a via (10), the via (10) being arranged in at least one first layer (12) for a multilayer printed circuit board (11), and a side wall of the via being provided with a metal layer (34) over the entire surface,
**characterized by the following steps:**
a) aligning a pin (21) perpendicular to a first opening (14) of the via (10);
b) inserting the pin (21) through the first opening (14) in the via (10);
c) shortening the pin (21) to a pin length in such a way that the pin length corresponds to part of a whole or a multiple of a length (23) of the via (10) ;
d) pressing the first layer (12) with a second layer (13), wherein a first prepreg layer (16) is arranged between the first layer (12) and the second layer (13), wherein, in step d), the first layer (12) is pressed with the second layer (13) until the pin (21) is deformed within the via (10) in such a way that substantially the whole of the via (10) is filled by the pin (21).

2. Method according to Claim 1,
**characterized in that**
in step d), the first layer (12) is pressed with a third layer (13a), wherein a second prepreg layer (17) is arranged between the first layer (12) and the third layer (13a), wherein the first layer (12) is arranged between the second layer (13) and the third layer (13a).

3. Method according to Claim 1 or 2,
**characterized in that**
in step b), the pin (21) is inserted into the via (10) through the first opening (14) over at least the entire length (23) of the via (10), wherein the pin (21) ends with the first layer (12) with its first end (24) in the region of a second opening (15) of the via (10) that is opposite the first opening (14), or projects out of the second opening (15).

4. Method according to one of the preceding claims, **characterized in that**
in step b), the pin (21) is inserted into the via (10) by a means (27) for the insertion of the pin (21), wherein the pin (21) is fed to the means (27) for the insertion of the pin (21) in the form of a rod or coiled.

5. Method according to one of the preceding claims, **characterized in that**
the pin (21) has a glass fibre fabric for stabilization.

6. Method according to one of the preceding claims, **characterized in that**
the pin (21) has an epoxy material.

7. Method according to one of the preceding claims, **characterized in that**
the pin (21) has a pin diameter (28) which is smaller than a diameter (29) of the via (10), and wherein the pin (21) has a round or angular cross section.

8. Method according to one of the preceding claims, **characterized in that**
following the shortening of the pin (21) in step c), the pin (21) projects with a first end (24) and/or second end (25) out of the first opening (14) of the via (10) and/or out of a second opening (15) of the via (10), opposite the first opening (14), over a first length and/or a second length.

9. Method according to Claim 8,
**characterized in that**
the first length and/or the second length (31) extends in a substantially straight line with the region of the pin (21) within the via (10).

10. Method according to Claim 8 or 9,
**characterized in that**
the pin (21) is bent in the region of its first end (24) and/or second end (25).

11. Method according to one of the preceding claims, **characterized in that**
following the pressing in step d), the multilayer, finally laminated printed circuit board (11) is pressed in a further method step, or heat is supplied to the said printed circuit board, at least in the region of the pin (21), in order to melt the material of the pin (21) and therefore to close the first opening (14).

## Revendications

1. Procédé de remplissage d'un trou métallisé (10), le trou métallisé (10) étant disposé dans au moins une première couche (12) pour un circuit imprimé multicouche (11), et une paroi latérale du trou métallisé (10) étant pourvue d'une couche métallique (34) sur la totalité de son pourtour,
**caractérisé par** les étapes suivantes :
a) orientation d'une broche (21) perpendiculairement à une première ouverture (14) du trou métallisé (10) ;
b) introduction de la broche (21) à travers la première ouverture (14) dans le trou métallisé (10) ;
c) raccourcissement de la broche (21) à une longueur de broche de telle sorte que la longueur de broche corresponde à une partie d'une totalité ou à un multiple d'une longueur (23) du trou métallisé (10) ;
d) pressage de la première couche (12) avec une deuxième couche (13), une première couche de préimprégné (16) étant disposée entre la première couche (12) et la deuxième couche (13), la première couche (12) étant pressée avec la deuxième couche (13) à l'étape d) jusqu'à ce que la broche (21) à l'intérieur du trou métallisé (10) se déforme de telle sorte que pour l'essentiel la totalité du trou métallisé (10) est remplie par la broche (21).

2. Procédé selon la revendication 1, **caractérisé en ce qu'**à l'étape d), la première couche (12) est pressée avec une troisième couche (13a), une deuxième première couche de préimprégné (16) étant disposée entre la première couche (12) et la troisième couche (13a), la première couche (12) étant disposée entre la deuxième couche (13) et la troisième couche (13a).

3. Procédé selon la revendication 1 ou 2, **caractérisé en ce qu'**à l'étape b), la broche (21) est introduite dans le trou métallisé (10) sur au moins la longueur (23) totale du trou métallisé (10) à travers la première ouverture (14), la broche (21) fermant avec sa première extrémité (24) le trou métallisé (10) avec la première couche (12) ou dépassant hors de la deuxième ouverture (15) dans la zone d'une deuxième ouverture (15) à l'opposé de la première ouverture (14).

4. Procédé selon l'une des revendications précédentes, **caractérisé en ce qu'**à l'étape b), la broche (21) est introduite dans le trou métallisé (10) au moyen d'un moyen (27) servant à introduire la broche (21), la broche (21) étant acheminée au moyen (27) servant à introduire la broche (21) en forme de tige ou enroulée.

5. Procédé selon l'une des revendications précédentes, **caractérisé en ce que** la broche (21) possède une structure en fibres de verre servant à la stabilisation.

6. Procédé selon l'une des revendications précédentes, **caractérisé en ce que** la broche (21) possède un matériau à base d'époxy.

7. Procédé selon l'une des revendications précédentes, **caractérisé en ce que** la broche (21) possède un diamètre de broche (28) qui est inférieur au diamètre du trou métallisé (10) et la broche (21) présentent une section transversale ronde ou polygonale.

8. Procédé selon l'une des revendications précédentes, **caractérisé en ce qu'**après le raccourcissement de la broche (21) à l'étape c), la broche (21) dépasse sur une première longueur et/ou une deuxième longueur avec sa première extrémité (24) et/ou deuxième extrémité (25) hors de la première ouverture (14) du trou métallisé (10) et/ou hors d'une deuxième ouverture du trou métallisé (10) à l'opposé de la première ouverture (14).

9. Procédé selon la revendication 8, **caractérisé en ce que** la première longueur et/ou la deuxième longueur (31) s'étend, avec la zone de la broche (21) à l'intérieur du trou métallisé (10), en une ligne sensiblement droite.

10. Procédé selon la revendication 8 ou 9, **caractérisé en ce que** la broche (21) est flambée dans la zone de sa première extrémité (24) et/ de sa deuxième extrémité (25).

11. Procédé selon l'une des revendications précédentes, **caractérisé en ce qu'**après le pressage à l'étape d), le circuit imprimé (11) multicouche stratifié terminé est pressé dans une étape supplémentaire ou de la chaleur est acheminée à celui-ci au moins dans la zone de la broche (21) afin de faire fondre la matière de la broche (21) et fermer ainsi la première ouverture (14).
